# EUROPEAN PATENT APPLICATION

(11) **EP 4 685 853 A1**
(43) Date of publication of application: **28.01.2026**
(21) Application number: 24774980.7
(22) Date of filing: 21.03.2024
(51) Int. Cl.: H01L 31/048, H01L 31/0749, H02S 10/40, H10K 30/40, H10K 30/50, H10K 30/88, H10K 39/15

(54) **PHOTOELECTRIC CONVERSION ELEMENT, PHOTOELECTRIC CONVERSION MODULE, AND PADDLE**

(30) Priority: 22.03.2023 JP 2023045499
(71) Applicant: Idemitsu Kosan Co.,Ltd., Tokyo 100-8321 (JP)
(72) Inventor: TOMITA Hiroshi, Tokyo 100-8321 (JP); TOMAI Shigekazu, Tokyo 100-8321 (JP)
(74) Representative: Hoffmann Eitle
(86) International application number: PCT/JP2024/011173
(87) International publication number: WO 2024/195846

(57) **Abstract**

Provided is a photoelectric conversion element capable of improving oxidation resistance while maintaining moisture resistance. A photoelectric conversion element (10) comprises: a film formation substrate (20); at least one photoelectric conversion layer (26) provided on the film formation substrate (20); a distal-side conductive layer (24), among conductive layers electrically connected to the photoelectric conversion layer (26), located farthest from the film formation substrate (20); a sealing layer (30) provided on the distal-side conductive layer (24); and a barrier layer (32) provided on at least a portion of an upper surface and a side surface of the sealing layer (30). The sealing layer (30) contains a paraxylylene-based polymer. The barrier layer (32) contains at least one of an inorganic metal oxide, an inorganic metal nitride and an inorganic metal oxynitride, or a precursor thereof.

## Description

### Technical Field

The present invention relates to a photoelectric conversion element, a photoelectric conversion module, and a paddle.

### Background Art

Examples of the type of photoelectric conversion element such as a solar cell include a crystalline photoelectric conversion element and a thin-film photoelectric conversion element. The crystalline photoelectric conversion element includes, for example, crystalline silicon as a photoelectric conversion layer. The thin-film photoelectric conversion element includes, as a photoelectric conversion layer, for example, amorphous silicon, a CIS-based or CIGS-based compound, or a compound having a perovskite structure (perovskite-type compound). The following Cited Literature 1 discloses a photoelectric conversion element containing a perovskite-type compound.

The photoelectric conversion element described in Cited Literature 1 includes a perovskite layer as a photoelectric conversion layer, a hole transport layer (Spiro-MeOTAD) on the perovskite layer, and a protective film on the hole transport layer. The protective film is formed of poly(chloro-p-xylene)). Poly(chloro-p-xylene)) has a relatively low water vapor transmission rate and high water repellency, and therefore stability of the perovskite layer against humidity is improved.

### Citation List

### Non Patent Literature

Non Patent Literature 1: Hyojung Kim, et., al., Scientific Reports, vol. 9, 15461 (2019)

### Summary

The inventors of the present application have found the following problems. At positions of relatively high altitude on Earth and/or in outer space, an ultraviolet radiation intensity is high and highly active atomic oxygen is present. When highly active atomic oxygen is present, oxidation of poly(chloro-p-xylene)) proceeds. Therefore, there is a possibility that long-term stability of the photoelectric conversion element may be deteriorated.

Therefore, a photoelectric conversion element capable of improving oxidation resistance while maintaining moisture resistance is desired.

In one aspect, a photoelectric conversion element comprises: a film formation substrate; at least one photoelectric conversion layer provided on the film formation substrate; a distal-side conductive layer, among conductive layers electrically connected to the photoelectric conversion layer, located farthest from the film formation substrate; a sealing layer provided on the distal-side conductive layer; and a barrier layer provided on at least a portion of an upper surface and a side surface of the sealing layer. The sealing layer contains a paraxylylene-based polymer. The barrier layer contains at least one of an inorganic metal oxide, an inorganic metal nitride and an inorganic metal oxynitride, or a precursor thereof.

### Brief Description of Drawings

Fig. 1 is a schematic cross-sectional view of a photoelectric conversion element according to a first embodiment.
Fig. 2 is a schematic cross-sectional view of a photoelectric conversion element according to a second embodiment.
Fig. 3 is a schematic cross-sectional view of a photoelectric conversion element according to a third embodiment.
Fig. 4 is a schematic cross-sectional view of a photoelectric conversion element according to a fourth embodiment.
Fig. 5 is a schematic plan view of a photoelectric conversion module according to a fifth embodiment.
Fig. 6 is a schematic perspective view of an artificial satellite including a photoelectric conversion module.

### Description of Embodiments

Hereinafter, embodiments will be described with reference to the drawings. In the following drawings, the same or similar parts are denoted by the same or similar reference numerals. However, it should be noted that the drawings are schematic, and ratios of dimensions and the like may be different from actual ones.

### [First Embodiment]

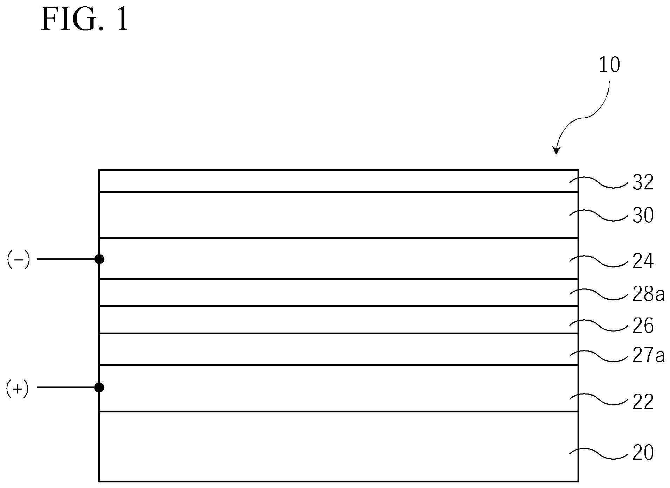

Fig. 1 is a schematic cross-sectional view of a photoelectric conversion element according to a first embodiment. A photoelectric conversion element 10 according to the first embodiment may be a thin-film photoelectric conversion element. The photoelectric conversion element 10 is preferably a solar cell element that converts light energy into electrical energy.

The photoelectric conversion element 10 includes a film formation substrate 20 as a base for forming each film. The film formation substrate 20 may be formed of, for example, glass, ceramic, resin, or metal. The film formation substrate 20 may be a flexible substrate. The shape and dimensions of the film formation substrate 20 are appropriately determined according to the size or the like of the photoelectric conversion element 10.

In a case where a metal substrate is adopted as the film formation substrate 20, the film formation substrate 20 is formed of, for example, titanium (Ti), stainless steel (SUS), copper, aluminum, or an alloy thereof. Alternatively, the film formation substrate 20 may have a stacked structure in which a plurality of metal substrates are stacked. For example, a stainless-steel foil, a titanium foil, or a molybdenum foil may be formed on a surface of the film formation substrate 20.

The photoelectric conversion element 10 may include at least a first conductive layer 22, a second conductive layer 24, and a photoelectric conversion layer 26 provided between the first conductive layer 22 and the second conductive layer 24. The first conductive layer 22, the photoelectric conversion layer 26, and the second conductive layer 24 are provided on the film formation substrate 20. The photoelectric conversion layer 26 is a layer that contributes to mutual conversion between light energy and electric energy. In a solar cell element that converts light energy into electric energy, the photoelectric conversion layer 26 may be referred to as a light absorption layer.

The first conductive layer 22 and the second conductive layer 24 are layers that function as an anode or a cathode. The first conductive layer 22 and the second conductive layer 24 are adjacent to the photoelectric conversion layer 26 and are electrically connected to the photoelectric conversion layer 26. In the present specification, it is noted that the term "adjacent" means not only that both layers are in direct contact, but also that both layers are in proximity via another layer.

The first conductive layer 22 is provided on the film formation substrate 20 and is provided between the photoelectric conversion layer 26 and the film formation substrate 20. The second conductive layer 24 is provided on the photoelectric conversion layer 26, and is located on a side opposite the film formation substrate 20 with respect to the photoelectric conversion layer 26. The second conductive layer 24 is a distal-side conductive layer located farthest from the film formation substrate 20 among the conductive layers electrically connected to the photoelectric conversion layer 26 in the thickness direction of the photoelectric conversion element 10.

In the first embodiment, the second conductive layer 24 may be formed of a transparent conductive layer. In the present specification, the "transparent conductive layer" means a conductive layer having light transparency. In the present specification, "having light transparency" means that 10% or more of light having any wavelength of 200 nm to 2000 nm is transmitted. In a case where the second conductive layer 24 is formed of a transparent conductive layer, light incident on the photoelectric conversion layer 26 or emitted from the photoelectric conversion layer 26 is transmitted through the second conductive layer 24.

The first conductive layer 22 may be formed of an opaque conductive layer or a transparent conductive layer. The first conductive layer 22 may be formed of, for example, a metal such as molybdenum, titanium, or chromium. Although not particularly limited, the thickness of the first conductive layer 22 may be, for example, 50 nm to 1500 nm.

In the first embodiment, as a preferred example, the second conductive layer 24 may be formed of an n-type semiconductor, more specifically, a material having n-type conductivity and relatively low resistance. The second conductive layer 24 can also function as an n-type semiconductor and a transparent conductive layer. The second conductive layer 24 includes, for example, a metal oxide to which a Group III element (B, Al, Ga, or In) is added as a dopant. Here, the description of "Group" of an element in the present specification is based on the short-form periodic table (the same applies hereinafter).

The metal oxide forming the second conductive layer 24 can be selected from, for example, indium tin oxide (In₂O₃:Sn), indium titanium oxide (In₂O₃:Ti), indium zinc oxide (In₂O₃:Zn), tin-zinc-doped indium oxide (In₂O₃:Sn,Zn), tungsten-doped indium oxide (In₂O₃:W), hydrogen-doped indium oxide (In₂O₃:H), indium gallium zinc oxide (InGaZnO₄), zinc tin oxide (ZnO:Sn), fluorine-doped tin oxide (SnO₂:F), gallium doped zinc oxide (ZnO:Ga), boron-doped zinc oxide (ZnO:B), and aluminum-doped zinc oxide (ZnO:Al).

Although not particularly limited, the thickness of the second conductive layer 24 may be, for example, 500 nm to 2500 nm.

The photoelectric conversion layer 26 may include, for example, a p-type semiconductor. In a specific example, the photoelectric conversion layer 26 may function as, for example, a polycrystalline or microcrystalline p-type compound semiconductor layer.

In the first embodiment, the photoelectric conversion layer 26 includes a chalcogen compound layer. The chalcogen compound is a compound containing at least one chalcogen element. The chalcogen compound includes, for example, a sulfide, a selenide, and/or a telluride. Specifically, the photoelectric conversion layer 26 may include a Group I-III-VI₂ compound semiconductor layer having a chalcopyrite structure. Here, the Group I element can be selected from copper (Cu), silver (Ag), gold (Au), and the like. The Group III element can be selected from indium (In), gallium (Ga), aluminum (Al), or the like. In addition, the photoelectric conversion layer 26 may contain tellurium (Te) or the like in addition to selenium (Se) or sulfur (S), as a Group VI element. The photoelectric conversion layer 26 may contain an alkali metal such as Li, Na, K, Rb, or Cs.

Alternatively, the photoelectric conversion layer 26 may include a Group I₂-(II-IV)-VI₄ compound semiconductor layer which is a CZTS-based chalcogen compound containing Cu, Zn, Sn, S, or Se. Representative examples of the CZTS-based chalcogen semiconductor include those using a compound such as Cu₂ZnSnSe₄ or Cu₂ZnSn(S,Se)₄.

The photoelectric conversion element 10 may have a first buffer layer 27a between the photoelectric conversion layer 26 and the first conductive layer 22 if necessary. In this case, the first buffer layer 27a may be a semiconductor material having the same conductivity type as that of the first conductive layer 22, or may be a semiconductor material having a different conductivity type. The first buffer layer 27a may be formed of a material having a higher electrical resistance than that of the first conductive layer 22.

The first buffer layer 27a is not particularly limited, but may be, for example, a layer containing a chalcogenide compound of a transition metal element having a layered structure. Specifically, the first buffer layer 27a may be formed of a transition metal material such as Mo, W, Ti, V, Cr, Nb, or Ta, and a compound including a chalcogen element such as O, S, or Se. The first buffer layer 27a may be, for example, a Mo(Se,S)₂ layer, a MoSe₂ layer, or a MoS₂ layer. The first buffer layer 27a can be formed on a surface of the first conductive layer 22 by chalcogenizing a precursor layer used as a precursor of the photoelectric conversion layer 26.

The photoelectric conversion element 10 may have a second buffer layer 28a between the photoelectric conversion layer 26 and the second conductive layer 24 if necessary. In this case, the second buffer layer 28a may be a semiconductor material having the same conductivity type as that of the second conductive layer 24, or may be a semiconductor material having a different conductivity type. The second buffer layer 28a may be formed of a material having a higher electrical resistance than that of the second conductive layer 24.

The second buffer layer 28a is provided on the photoelectric conversion layer 26. Although not particularly limited, the thickness of the second buffer layer 28a may be, for example, 10 nm to 100 nm.

The second buffer layer 28a can be selected from compounds containing zinc (Zn), cadmium (Cd), or indium (In). Examples of the compound containing zinc include ZnO, ZnS, Zn(OH)₂, or Zn(O,S) and Zn(O,S,OH) which are mixed crystals thereof, and further include ZnMgO and ZnSnO. Examples of the compound containing cadmium include CdS and CdO, and Cd(O,S) and Cd(O,S,OH) which are mixed crystals thereof. Examples of the compound containing indium include In₂S₃ and In₂O₃, and In₂(O,S)₃ and In₂(O,S,OH)₃ which are mixed crystals thereof, and In₂O₃, In₂S₃, In (OH)ₓ and the like can be used. In addition, the second buffer layer 28a may have a stacked structure of these compounds.

Note that the second buffer layer 28a has an effect of improving characteristics such as photoelectric conversion efficiency, but may be omitted. In a case where the second buffer layer 28a is omitted, the second conductive layer 24 is formed directly on the photoelectric conversion layer 26.

It should be noted that the stacked structure of the photoelectric conversion element 10 is not limited to the above aspect, and may take various aspects. For example, the photoelectric conversion element 10 may have a configuration in which both the n-type semiconductor and the p-type semiconductor are sandwiched between the first conductive layer and the second conductive layer. In this case, the second conductive layer may not be formed of an n-type semiconductor. In addition, the photoelectric conversion element 10 is not limited to a p-n junction-type structure, and may have a p-i-n junction-type structure including an intrinsic semiconductor layer (i-type semiconductor) between an n-type semiconductor and a p-type semiconductor.

In the first embodiment, the photoelectric conversion element 10 includes a sealing layer 30 provided on the second conductive layer 24 and a barrier layer 32 provided on the sealing layer 30. The sealing layer 30 is located farther from the film formation substrate 20 than the second conductive layer 24 in the cross section illustrated in Fig. 1. That is, the sealing layer 30 is located outside the second conductive layer 24.

The sealing layer 30 seals and protects the second conductive layer 24 and the photoelectric conversion layer 26. In Fig. 1, the sealing layer 30 covers only an upper surface of the second conductive layer 24. The present invention is not limited thereto, and the sealing layer 30 may cover not only the upper surface of the second conductive layer 24 but also side surfaces of the second conductive layer 24, the photoelectric conversion layer 26 and/or the first conductive layer 22.

The sealing layer 30 contains a paraxylylene-based polymer as a main component. Since the paraxylylene-based polymer has a relatively low moisture permeability among polymer materials, the second conductive layer 24, the photoelectric conversion layer 26 or the like can be protected from humidity. In addition, since defects such as cracks are less likely to occur during coating, the paraxylylene-based polymer is excellent for the purpose of sealing. Furthermore, the paraxylylene-based polymer is superior to other polymers that form a sealing material also from the viewpoint of heat resistance.

As the paraxylylene-based polymer, for example, the following polymers can be used. The following Chemical Formula (1) is a polymer having a linear structure having no functional group in the aromatic ring. The following

Chemical Formula (2) is a polymer in which one of aromatic ring hydrogens is substituted with chlorine. The following Chemical Formula (3) is a polymer in which one of aromatic ring hydrogens is substituted with a methyl group. The following Chemical Formula (4) is a polymer in which one of methylene groups is fluorinated. The following Chemical Formula (5) is a polymer in which hydrogens at 2- and 5-positions of an aromatic ring are substituted with chlorine. The following Chemical Formula (6) is a polymer in which two methylene groups are fluorinated.

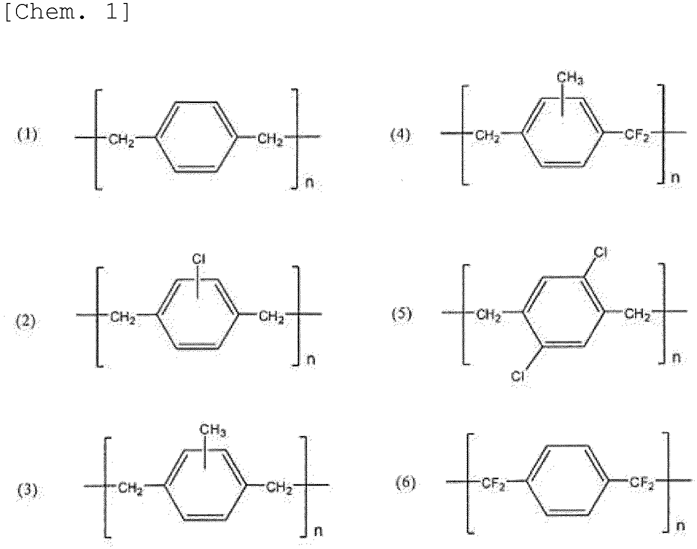

The paraxylylene-based polymer described above has light transparency. Therefore, the paraxylylene-based polymer can be suitably used even in a case where light is incident on or emitted from the second conductive layer 24 side to the photoelectric conversion layer 26.

The photoelectric conversion element 10 has a barrier layer 32 provided on at least a part of an upper surface and a side surface of the sealing layer 30. In Fig. 1, the barrier layer 32 is drawn to cover only the upper surface of the sealing layer 30, but the barrier layer 32 may also cover the side surface of the sealing layer 30. The barrier layer 32 preferably covers the entire sealing layer 30. The sealing layer 30 is provided between the barrier layer 32 and the second conductive layer 24. Therefore, the barrier layer 32 may not be electrically connected to the second conductive layer 24 or the photoelectric conversion layer 26.

The barrier layer 32 is a layer having an oxygen barrier property. The oxygen permeability of the barrier layer 32 is preferably lower than the oxygen permeability of the sealing layer 30. From this viewpoint, the barrier layer 32 contains at least one of an inorganic metal oxide, an inorganic metal nitride and an inorganic metal oxynitride, or a precursor thereof. The barrier layer 32 preferably contains an oxide, nitride or oxynitride of silicon, aluminum or indium tin, as a main component. The barrier layer 32 more preferably has a water vapor barrier property.

Specifically, the compound forming the barrier layer 32 may have, for example, at least one selected from the group consisting of ITO, TiOₓ, SiO₂-Al₂O₃, AlOₓ, AlON, SiOₓ, SiON, SiN, Y₂O₃, ZrO₂, CaO, MgO, Ga₂O₃, MnO₂, and CeO₂.

Such a barrier layer 32 is less likely to transmit oxygen or atomic oxygen, so that oxidation of the paraxylylene-based polymer forming the sealing layer 30 can be suppressed.

The barrier layer 32 preferably has light transparency. The compounds listed above as the materials forming the barrier layer 32 generally have light transparency. When the barrier layer 32, the sealing layer 30, and the second conductive layer 24 have light transparency, light can pass through the barrier layer 32, the sealing layer 30, and the second conductive layer 24, and be incident on the photoelectric conversion layer 26 or be emitted from the photoelectric conversion layer 26.

A refractive index (absolute refractive index, and the same applies hereinafter) of the barrier layer 32 at a wavelength of 589.3 nm is preferably smaller than a refractive index of the sealing layer 30 at a wavelength of 589.3 nm. As a result, when light travels from the barrier layer 32 toward the sealing layer 30, reflection at the interface between the barrier layer 32 and the sealing layer 30 is suppressed. Therefore, light can effectively reach the photoelectric conversion layer 26.

Here, the paraxylylene-based polymer forming the sealing layer 30 has a refractive index of about 1.6 at a wavelength of 589.3 nm. Therefore, the refractive index of the barrier layer 32 at a wavelength of 589.3 nm is preferably smaller than 1.6 or 1.56, for example. Examples of a material having such a refractive index include silicon dioxide (SiO₂). Therefore, the barrier layer 32 more preferably has silicon dioxide or a precursor thereof.

The refractive index of the second conductive layer 24 at a wavelength of 589.3 nm is preferably greater than the refractive index of the sealing layer 30 at a wavelength of 589.3 nm. The refractive index of the second conductive layer 24 at a wavelength of 589.3 nm is preferably greater than 1.6 or 1.7, for example. Examples of a material having such a refractive index include indium tin oxide (ITO). As a result, when light travels from the sealing layer 30 toward the second conductive layer 24, reflection at the interface between the sealing layer 30 and the second conductive layer 24 is suppressed. Therefore, light can effectively reach the photoelectric conversion layer 26.

As described above, the barrier layer 32 may be a precursor of at least one of an inorganic metal oxide, an inorganic metal nitride and an inorganic metal oxynitride. Examples of the precursor of silicon dioxide, silicon nitride and/or silicon oxynitride include siloxane and polysilazane. Siloxane is a compound having a Si-O-Si bond and having silicon and oxygen as skeletons. Polysilazane is a polymer having "-(SiH₂NH)-" as a basic unit.

Siloxane and polysilazane are known to form silicon dioxide (SiO₂), silicon nitride (SiN) and/or silicon oxynitride (SiON) by being exposed to atomic oxygen. Therefore, in a case where the barrier layer 32 contains siloxane or polysilazane, the barrier layer 32 of the photoelectric conversion element 10 contains silicon dioxide (SiO₂), silicon nitride (SiN) and/or silicon oxynitride (SiON) by being exposed to atomic oxygen. Silicon dioxide (SiO₂), silicon nitride (SiN) and/or silicon oxynitride (SiON) are suitable for oxygen barrier purposes as previously described.

The photoelectric conversion element 10 may not include a glass layer such as a cover glass on the second conductive layer 24, that is, outside the second conductive layer 24. When a glass layer such as a cover glass is provided, the weight of the photoelectric conversion element 10 increases, which causes a loss of flexibility of the photoelectric conversion element 10. In the above embodiment, the sealing layer 30 and the barrier layer 32 may be used as an alternative to a glass layer such as a cover glass.

In the above embodiment, the sealing layer 30 is in direct contact with the second conductive layer 24. Alternatively, another layer may be provided between the second conductive layer 24 and the sealing layer 30 for the purpose of sealing and/or the purpose of suppressing reflection of light.

In the above embodiment, the barrier layer 32 is in direct contact with the sealing layer 30. Alternatively, another layer may be provided between the sealing layer 30 and the barrier layer 32 for the purpose of sealing and/or the purpose of suppressing reflection of light.

Furthermore, in the above embodiment, the barrier layer 32 forms the outermost surface of the photoelectric conversion element 10. Alternatively, another layer may be provided on the barrier layer 32 for the purpose of sealing and/or the purpose of suppressing reflection of light.

In the first embodiment, the photoelectric conversion element 10 including the photoelectric conversion layer 26 containing a CIS-based or CIGS-based compound has been mainly described. The photoelectric conversion layer 26 is not limited thereto, and may contain any compound capable of forming a thin-film photoelectric conversion element.

The photoelectric conversion element 10 according to the first embodiment has high moisture resistance and high oxidation resistance. In particular, resistance to highly active atomic oxygen can also be improved. Therefore, the photoelectric conversion element 10 can be suitably mounted on an electric device disposed at a position of relatively high altitude on Earth and/or in outer space. Examples of such electric devices include floating bodies such as balloons, airplanes, rockets, and space stations, moving bodies, and flying bodies. However, it should be noted that the application of the photoelectric conversion element 10 is not limited to these applications, and can be applied to ground, for example.

### [Second Embodiment]

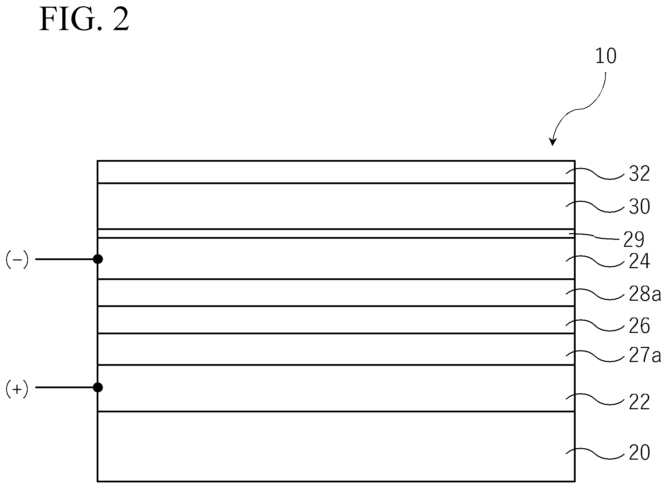

Fig. 2 is a schematic cross-sectional view of a photoelectric conversion element according to a second embodiment. In the second embodiment, the same components as those in the first embodiment are denoted by the same reference numerals. In addition, it should be noted that the same components as those of the first embodiment are denoted by the same reference numerals for which description is omitted.

In the second embodiment, the photoelectric conversion element 10 includes an inorganic oxide layer 29 between the sealing layer 30 and the second conductive layer 24. Other components of the photoelectric conversion element 10 according to the second embodiment are similar to those of the first embodiment.

The inorganic oxide layer 29 preferably functions as an oxygen barrier. From such a viewpoint, the inorganic oxide layer 29 may include, for example, silicon dioxide (SiO₂) or aluminum oxide (Al₂O₃). As a result, the oxidation resistance of the photoelectric conversion element 10 can be further improved.

In the second embodiment, a refractive index of the inorganic oxide layer 29 at a wavelength of 589.3 nm is preferably greater than the refractive index of the sealing layer 30 at a wavelength of 589.3 nm and is smaller than the refractive index of the second conductive layer 24 at a wavelength of 589.3 nm. As a result, reflection of light is suppressed at the interface between the sealing layer 30 and the inorganic oxide layer 29 and the interface between the inorganic oxide layer 29 and the second conductive layer 24. Therefore, light can be allowed to more effectively reach the photoelectric conversion layer 26.

For example, when the material forming the sealing layer 30 is a paraxylylene-based polymer, the material forming the second conductive layer 24 is indium tin oxide (ITO), and the material forming the inorganic oxide layer 29 is aluminum oxide (Al₂O₃), the relationship of the above-mentioned refractive index can be realized.

### [Third Embodiment]

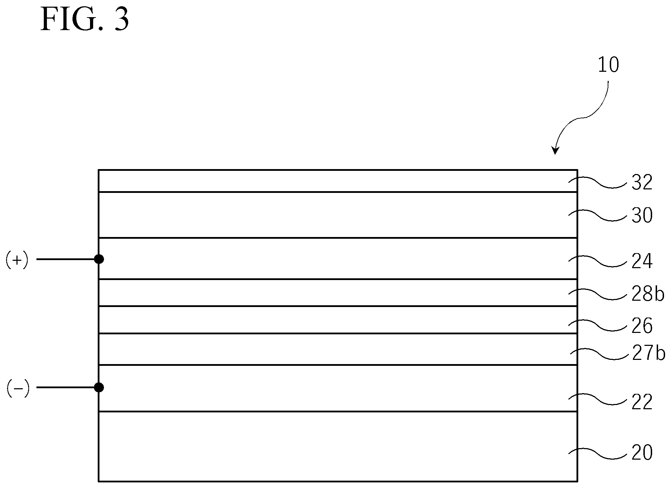

Fig. 3 is a schematic cross-sectional view of a photoelectric conversion element according to a third embodiment. In the third embodiment, the same components as those in the first embodiment are denoted by the same reference numerals. In addition, it should be noted that the same components as those of the first embodiment are denoted by the same reference numerals for which description is omitted.

The photoelectric conversion element 10 according to the third embodiment may include a film formation substrate 20, a first conductive layer 22, an electron transport layer 27b, a photoelectric conversion layer (light absorption layer) 26, a hole transport layer 28b, and a second conductive layer 24. The first conductive layer 22, the electron transport layer 27b, the photoelectric conversion layer 26, the hole transport layer 28b, and the second conductive layer 24 are provided on the film formation substrate 20. The second conductive layer 24 is a distal-side conductive layer located farthest from the film formation substrate 20 among the conductive layers electrically connected to the photoelectric conversion layer 26.

In the third embodiment, the film formation substrate 20 can be selected from a transparent glass substrate such as soda-lime glass or alkali-free glass, a resin substrate, a metal substrate, a ceramic substrate, or the like. In the third embodiment, the film formation substrate 20 may be a substrate having light transparency. In this case, light can pass through the film formation substrate 20, and be incident on the photoelectric conversion layer 26 or emitted from the photoelectric conversion layer 26.

The first conductive layer 22 may be a layer that acts as a cathode of the photoelectric conversion element. In the third embodiment, the first conductive layer 22 has light transparency. Examples of the material forming the first conductive layer 22 include conductive transparent materials such as copper iodide (CuI), indium tin oxide (ITO), tin oxide (SnO₂), fluorine-doped tin oxide (FTO), aluminum-doped zinc oxide (AZO), indium zinc oxide (IZO), or gallium-doped zinc oxide (GZO). The above materials may be used singly or as a mixture of two or more kinds thereof.

Although not particularly limited, the thickness of the first conductive layer 22 is preferably in a range of 100 nm to 5000 nm. As a result, sufficient conductivity can be maintained in the first conductive layer 22, and a light transmittance ratio of the first conductive layer 22 can be easily maintained relatively high.

The electron transport layer 27b has a function of transporting electrons generated by photoexcitation of the photoelectric conversion layer 26 to the first conductive layer 22. Therefore, the electron transport layer 27b is preferably formed of a material having characteristics that electrons generated in the photoelectric conversion layer 26 can easily move to the electron transport layer 27b and electrons of the electron transport layer 27b can easily move to the first conductive layer 22. The electron transport layer 27b may have light transparency.

Examples of the material of the electron transport layer 27b include inorganic materials such as titanium oxide (TiO₂), tungsten oxide (such as WO₂, WO₃, or W₂O₃), zinc oxide (ZnO), niobium oxide (such as Nb₂O₅), tantalum oxide (such as Ta₂O₅), yttrium oxide (such as Y₂O₃), strontium titanate (such as SrTiO₃), and tin oxide (SnO₂), and organic materials such as fullerene (such as C60 or C70) and derivatives thereof (such as PC₆₀BM, PC₇₀BM, ICBA, hydrogenated C60, or hydroxylated C60). The above materials may be used singly, or may be a mixture of two or more kinds thereof. The electron transport layer 27b may have a single layer structure or a stacked structure including a plurality of layers.

In the third embodiment, the photoelectric conversion layer 26 contains a compound having a perovskite structure (perovskite type compound), and has a function of generating electrons and holes by absorbing incident light. In the photoelectric conversion layer 26, electrons with low energy in a substance forming the photoelectric conversion layer are photoexcited by incident light, and electrons and holes with higher energy are generated. Electrons generated by photoexcitation move to the electron transport layer 27b, and holes generated by photoexcitation move to the hole transport layer 28b.

The hole transport layer 28b is located between the photoelectric conversion layer 26 and the second conductive layer 24. The hole transport layer 28b has a function of capturing holes generated in the photoelectric conversion layer 26 and moving the holes to the second conductive layer 24 as an anode. The hole transport layer 28b may contain a matrix component formed of, for example, 2,2',7,7'-tetrakis-(N,N-di-p-methoxyphenylamine)9,9'-spirobifluorene (Spiro-OMeTAD) or poly[bis(4-phenyl) (2,4,6-trimethylphenyl)amine] (PTAA), or may contain an organic low-molecular thin film that preferentially captures holes such as [2-(9Hcarbazole-9-yl) ethyl] phosphonic acid (2PACz). Optionally, in order to suppress recombination of holes and electrons, a passivate layer (not illustrated) formed of a metal oxide or an organic thin film may be provided between the photoelectric conversion layer 26 and the hole transport layer 28b.

The second conductive layer 24 acts as an anode of the photoelectric conversion element. The second conductive layer 24 may be formed on the hole transport layer 28b and may be in contact with the hole transport layer 28b.

Examples of a material of the second conductive layer 24 include metal materials such as gold, silver, copper, aluminum, and nickel, conductive transparent materials such as copper iodide (CuI), indium tin oxide (ITO), tin oxide (SnO₂), fluorine-doped tin oxide (FTO), aluminum-doped zinc oxide (AZO), indium zinc oxide (IZO), and gallium-doped zinc oxide (GZO), and conductive transparent polymers. The above materials may be used singly or as a mixture of two or more kinds thereof.

Also in the third embodiment, the sealing layer 30 is provided on the second conductive layer 24, and the barrier layer 32 is provided on the sealing layer 30. The materials forming the sealing layer 30 and the barrier layer 32 are as described in the first embodiment. However, in the third embodiment, the film formation substrate 20, the first conductive layer 22, and the electron transport layer 27b have light transparency. In this case, light can be incident on or emitted from the photoelectric conversion layer 26, from the first conductive layer 22 side. Therefore, the sealing layer 30, the barrier layer 32, and/or the second conductive layer 24 may have light transparency or may not have light transparency. Thus, the choice of materials for forming the barrier layer 32 may be increased.

Optionally, a buffer layer (not illustrated) may be formed between the second conductive layer 24 and the hole transport layer 28b. The buffer layer may be formed of, for example, molybdenum oxide.

In the third embodiment, the photoelectric conversion element 10 including the photoelectric conversion layer 26 containing a perovskite-type compound has been mainly described. The photoelectric conversion layer 26 is not limited thereto, and may contain any compound capable of forming a thin-film photoelectric conversion element.

### [Fourth Embodiment]

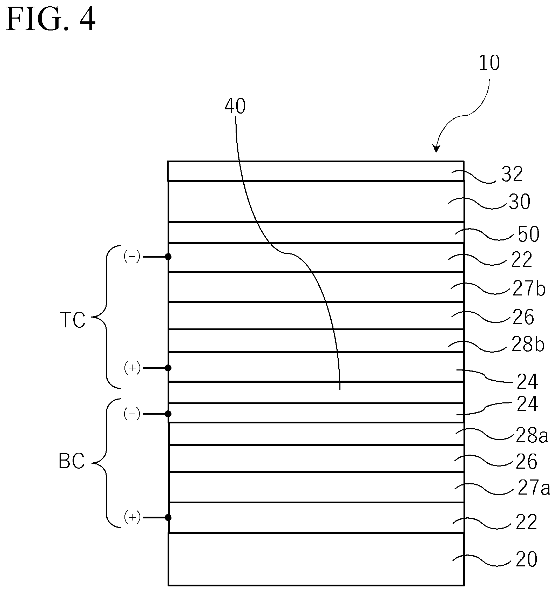

Fig. 4 is a schematic cross-sectional view of a photoelectric conversion element according to a fourth embodiment. In the fourth embodiment, the same components as those in the third embodiment are denoted by the same reference numerals. In addition, it should be noted that the same components as those of the third embodiment are denoted by the same reference numerals for which description is omitted.

The photoelectric conversion element 10 according to the fourth embodiment is a so-called multi-junction photoelectric conversion element. The multi-junction photoelectric conversion element includes a plurality of photoelectric conversion cells TC and BC stacked on each other. That is, the multi-junction photoelectric conversion element may include a plurality of photoelectric conversion layers 26.

The photoelectric conversion element 10 according to the fourth embodiment has a stacked structure in which the top cell TC and the bottom cell BC are stacked on each other. Each of the top cell TC and the bottom cell BC may have a stacked structure capable of photoelectric conversion. In the configuration illustrated in Fig. 4, light is incident from the top cell TC side (upper side in the drawing). Of the incident light, short wavelength light is photoelectrically converted in the top cell TC. Further, among the incident light, long wavelength light that has passed through the top cell TC is photoelectrically converted in the bottom cell BC.

The photoelectric conversion element 10 illustrated in Fig. 4 has a so-called four-terminal tandem structure including four terminals including two positive electrodes and two negative electrodes. In this case, the photoelectric conversion element 10 may have an intermediate layer 40 between the top cell TC and the bottom cell BC. The intermediate layer 40 may be an insulating layer having light transparency.

The bottom cell BC may include a film formation substrate 20, a first electrode layer 22, a first buffer layer 27a, a photoelectric conversion layer 26, a second buffer layer 28a, and a second electrode layer 24. The first buffer layer 27a and the second buffer layer 28a are optional components and may not be provided. Respective materials forming the film formation substrate 20, the first electrode layer 22, the first buffer layer 27a, the photoelectric conversion layer 26, the second buffer layer 28a, and the second electrode layer 24 may be the same as those described in the first embodiment.

The present invention is not limited thereto, as the bottom cell BC, for example, a configuration of a compound photoelectric conversion element such as a CZTS photoelectric conversion element, a CIGS photoelectric conversion element, a CdTe photoelectric conversion element, or a GaAs photoelectric conversion element, or a known photoelectric conversion element such as an organic photoelectric conversion element can be applied.

The top cell TC may include a substrate 50, a first conductive layer 22, an electron transport layer 27b, a photoelectric conversion layer 26, a hole transport layer 28b, and a second conductive layer 24. The second conductive layer 24 is provided on the intermediate layer 40. The hole transport layer 28b is provided on the second conductive layer 24. The photoelectric conversion layer 26 is provided on the hole transport layer 28b. The electron transport layer 27b is provided on the photoelectric conversion layer 26. The first conductive layer 22 is provided on the electron transport layer 27b. The substrate 50 is provided on the first conductive layer 22. The materials forming the first conductive layer 22, the electron transport layer 27b, the photoelectric conversion layer 26, the hole transport layer 28b, and the second conductive layer 24 may be the same as those described in the third embodiment. The substrate 50 may have light transparency. The substrate 50 may be, for example, a resin substrate having light transparency, and may be for forming the top cell TC.

In the fourth embodiment, among the conductive layers 22 and 24 electrically connected to the photoelectric conversion layer 26, the distal-side conductive layer located farthest from the film formation substrate (film formation substrate of bottom cell BC) 20 is the first conductive layer 22 of the top cell TC.

In the fourth embodiment, the sealing layer 30 is provided on the distal-side conductive layer located farthest from the film formation substrate 20, that is, on the first conductive layer 22 of the top cell TC. The barrier layer 32 is provided on the sealing layer 30. That is, the sealing layer 30 and the barrier layer 32 are located outside the first conductive layer 22 of the top cell TC.

More specifically, the sealing layer 30 is provided on the substrate 50 provided on the first conductive layer 22 of the top cell TC. In Fig. 4, the sealing layer 30 covers only the upper surface of the substrate 50. The present invention is not limited thereto, and the sealing layer 30 may cover not only the upper surface of the substrate 50 but also the side surfaces of the layers forming the top cell TC and/or the bottom cell BC. The barrier layer 32 may be provided on at least a part of the upper surface and the side surface of the sealing layer 30. In Fig. 4, the barrier layer 32 is drawn to cover only the upper surface of the sealing layer 30, but the barrier layer 32 may also cover the side surface of the sealing layer 30.

The materials forming the sealing layer 30 and the barrier layer 32 are as described in the first embodiment. In the fourth embodiment, light is incident from the top cell TC side (upper side in the drawing). Therefore, the materials forming the sealing layer 30, the barrier layer 32, and the first conductive layer 22 of the top cell TC preferably have light transparency. Such a material is as described in the first embodiment.

The photoelectric conversion element 10 illustrated in Fig. 4 has a four-terminal tandem structure. Alternatively, the photoelectric conversion element may have a two-terminal tandem structure. In this case, the photoelectric conversion element may not include at least the two second conductive layers 24 illustrated in Fig. 4.

### [Fifth Embodiment]

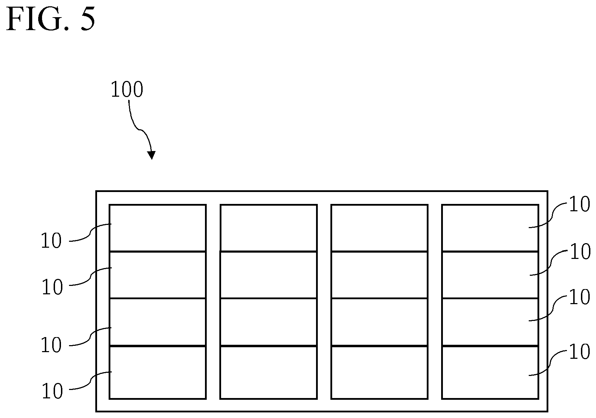

Next, a photoelectric conversion module according to a fifth embodiment will be described with reference to Fig. 5. Fig. 5 is a schematic plan view of a photoelectric conversion module according to a fifth embodiment.

A photoelectric conversion module 100 may include one or a plurality of photoelectric conversion elements 10. Fig. 5 illustrates the photoelectric conversion module 100 including a plurality of photoelectric conversion elements 10. The one or more photoelectric conversion elements 10 may be sealed with, for example, a sealing material. The configuration of each photoelectric conversion element 10 is as described in the first to fourth embodiments.

In a case where the photoelectric conversion module 100 includes the plurality of photoelectric conversion elements 10, the plurality of photoelectric conversion elements 10 may be arranged in at least one direction, preferably in a lattice pattern. In this case, the plurality of photoelectric conversion elements 10 may be electrically connected to each other in series and/or in parallel.

In the example illustrated in Fig. 5, among the photoelectric conversion elements 10 arranged in one direction, photoelectric conversion elements, which are adjacent to each other, partially overlap. Specifically, as illustrated in Fig. 5, the photoelectric conversion element 10 is disposed so as to cover a part of another photoelectric conversion element 10 adjacent thereto.

The photoelectric conversion elements 10 which are adjacent to each other may be electrically connected to each other by a connector. In this case, the connector may extend across the photoelectric conversion elements 10 which are adjacent to each other.

Instead of the aspect illustrated in Fig. 5, the photoelectric conversion elements 10 which are adjacent to each other may be arranged at intervals.

### [Artificial Satellite and Paddle for Artificial Satellite]

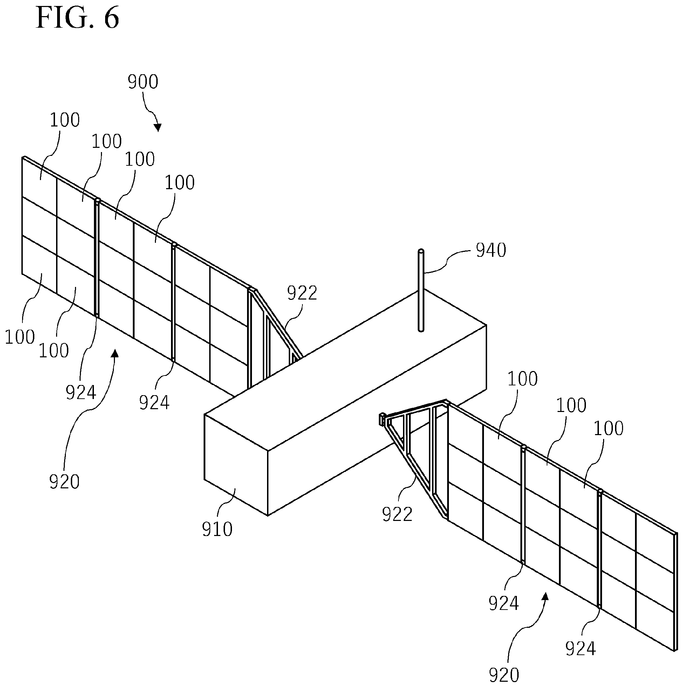

Next, an artificial satellite including a photoelectric conversion module and a paddle for an artificial satellite will be described. Fig. 6 is a schematic perspective view of an artificial satellite including a photoelectric conversion module. An artificial satellite 900 may include a base portion 910 and a paddle 920. The base portion 910 may include a device (not illustrated) necessary for controlling the artificial satellite 900 and the like. An antenna 940 may be attached to the base portion 910.

The paddle 920 may include the photoelectric conversion module 100 described above. The paddle 920 including the photoelectric conversion module 100 can be used as a power source for operating various devices provided in the base portion 910. As described above, the photoelectric conversion module 100 can be applied to a paddle for an artificial satellite. In particular, since the paddle 920 for an artificial satellite is exposed to a high temperature environment and a severe temperature change environment at the time of launching and operating the artificial satellite, it is desirable to use the photoelectric conversion module 100 including photoelectric conversion elements 10a and 10b having high heat resistance described above.

The paddle 920 may include a connecting portion 922 and a hinge portion 924. The connecting portion 922 corresponds to a portion connecting the paddle 920 to the base portion 910.

The hinge portion 924 extends along one direction, and the paddle 920 can be bent with the hinge portion 924 as a rotation axis. Each paddle 920 may have at least one, preferably a plurality of, hinge portions 924. Thus, the paddle 920 including the photoelectric conversion module 100 is configured to be small and foldable. When the artificial satellite 900 is launched, the paddle 920 may be in a folded state. The paddle 920 may be deployed when receiving sunlight to generate power.

Instead of the structure as illustrated in Fig. 6, the paddle 920 may have a cylindrical shape formed by being wound. Accordingly, the paddle 920 can take a substantially flat developed state by the rotation of the wound portion. When the artificial satellite 900 is launched, the paddle 920 may maintain a generally cylindrical shape. The paddle 920 only has to be deployed in a substantially flat state when receiving sunlight to generate power.

It should be noted that each feature described in each of the foregoing embodiments may be applied to or replaced with that of another embodiment as much as possible.

As described above, the contents of the present invention have been disclosed through the embodiments, but it should not be understood that the description and the drawings constituting a part of the disclosure limit the present invention. From this disclosure, various alternative embodiments, examples, and operational techniques will become apparent to those skilled in the art. Therefore, the technical scope of the present invention is defined only by the matters specifying the invention according to the claims appropriate from the above description.

This application claims priority based on Japanese Patent Application No. 2023-045499 filed on March 22, 2023, the entire contents of which are incorporated herein by reference.

## Claims

1. A photoelectric conversion element, comprising:
a film formation substrate;
at least one photoelectric conversion layer provided on the film formation substrate;
a distal-side conductive layer, among conductive layers electrically connected to the photoelectric conversion layer, located farthest from the film formation substrate;
a sealing layer provided on the distal-side conductive layer; and
a barrier layer provided on at least a portion of an upper surface and a side surface of the sealing layer,
wherein the sealing layer contains a paraxylylene-based polymer, and
the barrier layer contains at least one of an inorganic metal oxide, an inorganic metal nitride and an inorganic metal oxynitride, or a precursor thereof.

2. The photoelectric conversion element according to claim 1, wherein the barrier layer contains an oxide, a nitride or an oxynitride of silicon, aluminum or indium tin.

3. The photoelectric conversion element according to claim 1 or 2, wherein the distal-side conductive layer and the barrier layer have light transparency.

4. The photoelectric conversion element according to any one of claims 1 to 3, wherein a refractive index of the barrier layer at a wavelength of 589.3 nm is smaller than a refractive index of the sealing layer at a wavelength of 589.3 nm.

5. The photoelectric conversion element according to any one of claims 1 to 4, wherein the barrier layer contains silicon dioxide, silicon nitride and/or silicon oxynitride, or a precursor thereof.

6. The photoelectric conversion element according to claim 5, wherein the precursor includes siloxane or polysilazane.

7. The photoelectric conversion element according to any one of claims 1 to 6, wherein a refractive index of the distal-side conductive layer at a wavelength of 589.3 nm is greater than a refractive index of the sealing layer at a wavelength of 589.3 nm.

8. The photoelectric conversion element according to any one of claims 1 to 7, comprising
an inorganic oxide layer between the barrier layer and the distal-side conductive layer,
wherein a refractive index of the inorganic oxide layer at a wavelength of 589.3 nm is greater than a refractive index of the sealing layer at a wavelength of 589.3 nm and is smaller than a refractive index of the distal-side conductive layer at a wavelength of 589.3 nm.

9. A photoelectric conversion module comprising the photoelectric conversion element according to any one of claims 1 to 8.

10. A paddle comprising the photoelectric conversion module according to claim 9.
